# EUROPÄISCHE PATENTSCHRIFT

(11) **EP 3 292 604 B1**
(45) Veröffentlichungstag und Bekanntmachung des Hinweises auf die Patenterteilung: **25.08.2021**
(21) Anmeldenummer: 16726270.8
(22) Anmeldetag: 06.05.2016
(51) Int. Cl.: H02G 3/22

(54) **VERFAHREN ZUM HERSTELLEN EINER WANDDURCHFÜHRUNG FÜR MEHRERE KABEL SOWIE ANORDNUNG**
METHOD FOR PRODUCING A WALL LEAD-THROUGH FOR A PLURALITY CABLES AND ARRANGEMENT
PROCÉDÉ DE RÉALISATION D'UNE TRAVERSÉE MURAL POUR PLUSIEURS CÂBLES ET ENSEMBLE

(30) Priorität: 05.05.2015 DE 202015102280 U
(43) Veröffentlichungstag der Anmeldung: 14.03.2018
(73) Patentinhaber: CONTA-CLIP Verbindungstechnik GmbH, 33161 Hövelhof (DE)
(72) Erfinder: NOWASTOWSKI-STOCK, Jörg, 32760 Detmold (DE)
(74) Vertreter: Bittner, Thomas L.
(86) Internationale Anmeldenummer: PCT/DE2016/100205
(87) Internationale Veröffentlichungsnummer: WO 2016/177364

(56) Entgegenhaltungen:
- EP-A2- 1 710 882
- EP-A2- 1 710 882
- WO-A2-2010/011151
- DE-A1- 3 224 977
- DE-A1- 10 225 046
- DE-A1- 10 225 046
- DE-A1-102013 110 545
- DE-A1-102013 201 149
- DE-B3-102005 002 597
- DE-U1- 29 911 305
- DE-U1- 29 911 305
- US-A1- 2005 115 733
- US-B1- 7 806 374
- US-B1- 7 806 374

## Beschreibung

Die Erfindung betrifft ein Verfahren zum Herstellen einer Wanddurchführung für mehrere Kabel und eine Anordnung.

### Hintergrund

Wanddurchführungen für Kabel, die auch als Kabeldurchführungen bezeichnet werden können, dienen dazu, Kabel durch eine Wand hindurch von einer Seite zur anderen Seite zu führen. Solche Wanddurchführungen finden insbesondere Anwendung in Verbindung mit der Durchführung von Kabeln durch eine Gehäusewand eines Gerätes oder Schranks, zum Beispiel eines Schaltschranks. Derartige Wanddurchführungen können eine Abdichtung vorsehen, zum Beispiel zum Dichten gegen das Eindringen von Feuchtigkeit und Schmutz.

Wanddurchführungen können ein Gehäuse aus Kunststoff aufweisen, welches als Spritzgussbauteil hergestellt ist. Bei dieser oder anderen bekannten Ausführungen verfügt das Gehäuse über einen Gehäusedurchbruch, der einem Wanddurchbruch gegenüberliegend angeordnet ist, durch welchen hindurch die Kabel zu führen sind.

Aus dem Dokument DE 32 24 977 A1 ist eine von einem Einschnitt einer Wandung aufgenommene Kabeltülle zur dichten Durchführung eines Kabels oder Kabelsatzes durch eine Wandung bei Kraftfahrzeugen bekannt. Die Kabeltülle hat einen gelochten Grundkörper mit einstückig sich anschließender kegelstumpfförmiger Verlängerung, deren endseitige Manschette sich dichtend am Kabel abstützt. Der Grundkörper ist regelmäßig viereckig, zum Beispiel quadratisch. Die Kabeltülle weist äußere Schmalflächen auf, deren dem Einschnitt zugeordnete Bereiche über Nut- und Federverbindungen gehalten sind. Der Einschnitt nimmt mehrere solcher Kabeltüllen auf, deren aneinandergrenzende Schmalflächen ebenfalls über Nut- und Federverbindungen ineinandergreifen. So weist der Grundkörper zum Beispiel im Bereich zweier zueinander etwa paralleler äußerer Begrenzungskanten und in einer dritten, beide verbindenden und hierzu etwa rechtwinkligen Begrenzungskante jeweils in die dortige Schmalfläche eingetiefte Nuten auf. Im Bereich der vierten Begrenzungskante trägt der Grundkörper eine nach außen vorstehende Zunge, die bei aneinanderfügen mehrerer Kabeltüllen in eine Nut einer benachbarten Kabeltülle eingreifen.

Das Dokument DE 102 25 046 A1 betrifft eine Vorrichtung zum Verbinden einer Kabeldurchführung mit einem Wanddurchbruch. Die Vorrichtung umgibt den Wanddurchbruch allseitig und ist mit der Wand dicht und ortsfest verbindbar. Die Vorrichtung besitzt mindestens eine durchgehende Öffnung für Kabel und ist mit der Kabeldurchführung ortsfest und dichtverbindbar. Es ist mindestens ein Rastkörper vorgesehen, um die Kabeldurchführung mit der Vorrichtung lösbar verbinden zu können.

Im Dokument DE 10 2013 201 149 A1 ist eine Kabeldurchführungseinrichtung offenbart, die einen Dichtungsträger aufweist, welcher eine Kabeldurchführungsöffnung zur Anordnung einer Kabeldichtung aufweist. Der Dichtungsträger und die Kabeldichtung weisen eine sich parallel zu einer Kabeldurchführungsrichtung erstreckende Trennebene auf, wobei ein Verschraubungselement vorgesehen ist, das zur Anlage der Kabeldichtung gegen ein in der Kabeldurchführungsöffnung angeordnetes Kabel mit dem Dichtungsträger verschraubbar ist.

Aus dem Dokument DE 299 11 305 U1 ist ein Kabel-Stecker-Durchführungssystem für elektrische und / oder elektronische Bauteile aufnehmende Gehäuse bekannt. Das Durchführsystem sieht ein mehrteiliges Rasterbauteil mit Aufnahmen für Dichtungselemente vor, welches auf einer Seite eines Gehäusedurchbruchs zu montieren ist.

Ein mehrteiliges Gehäuse für eine Kabelwanddurchführung ist weiterhin aus dem Dokument US 7,806,374 B1 bekannt.

Im Dokument DE 102 25 046 A1 ist eine Vorrichtung zum Verbinden einer Kabeldurchführung mit einem Wanddurchbruch offenbart. Auf ein auf der Wand zu montierendes Gehäuse wird rückseitig ein mehrteiliges Rasterbauteil aufgebracht.

Eine Kabeldurchführung und ein Kabeldurchführungssystem sind weiterhin in dem Dokument EP 1 710 882 A1 beschrieben.

Aus dem Dokument WO 2010 / 011151 A2 ist eine Wanddurchführung für ein Rohrverbinder bekannt. Beim Herstellen der Wanddurchführung wird ein kubischer Abschnitt eines thermischen lsolators in einem Wanddurchbruch eingesteckt und hierbei auch durch ein Loch in einer Befestigungsplatte hindurchgesteckt, die auf der Innenseite der Wand mit dem Wanddurchbruch angeordnet ist. Auf diese Weise wird der kubische Abschnitt des thermischen Isolators in das Innere eines Solarkollektors eingebracht. In dieser Anordnung wird dann ein Rohrverbinder eingeführt, um auf der Außen- und der Innenseite jeweils einen Rohranschluss bereitzustellen. Auf dem Rohrverbinder ist ein Dichtungsring angeordnet.

Aus dem Dokument DE 10 2005 002 597 B3 ist eine Kabeldurchführung zum Durchführen von Leitungen, insbesondere von elektrischen Kabeln, durch eine Öffnung in einer Wand, einer Einrichtung oder eines Gehäuses bekannt. Die Kabeldurchführung umfasst einen in die Öffnung einsetzbar und darin befestigbaren Rahmen, der einen im Wesentlichen rechteckigen Innenraum begrenzt, und eine Vielzahl von in den Innenraum einsetzbaren, diesen ausfüllenden und darin festlegbaren Dichtungselemente, wobei zumindest in einem Teil der Dichtungselemente Kanäle zur Aufnahme der Leitungen ausgebildet sind. Erfindungsgemäß wird vorgeschlagen, dass der Rahmen an zwei gegenüberliegenden, nach innen gerichteten Seiten Führungsschienen aufweist, dass die Dichtungselemente beziehungsweise Verschiebemittel für die Dichtungselemente sich über die gesamte lichte Weite des Innenraums zwischen den Führungsschienen erstrecken und Vorsprünge aufweisen, mit denen sie in die Führungsschienen eingreifen. Nach dem Einsetzen der Verschiebemittel in den Innenraum werden diese durch Spannmittel festgelegt.

Dokument DE 10 2013 110 545 A1 bezieht sich auf eine Vorrichtung zur dichtenden Durchführung von Leitungen durch ein Trennelement mit einem Halteteil, das eine Mehrzahl Dichtungen aufweist, welche jeweils zur dichtenden Aufnahme einer Leitung vorgesehen sind, und mit einem Führungsteil, das mit dem Halteteil in Verbindung steht und das zur Durchführung der Leitungen durch ein Trennelement in einer Öffnung des Trennelementes anzuordnen ist. Das Halteteil und das Führungsteil stehen derart miteinander in Verbindung, dass sie in mindestens zwei unterschiedlichen Verbindungsstellungen aneinander arretierbar sind, wobei das Führungsteil in einer ersten Verbindungsstellung eine Entspannung der Dichtungen des Halteteils zulässt, während das Führungsteil in einer zweiten Verbindungsstellung, in die es aus der ersten Verbindungsstellung überführbar ist, so auf die Dichtungen einwirkt, dass diese zur Abdichtung einer jeweils zugeordneten Leitung deformiert sind.

Das Dokument US 2005 / 0 115 733 A1 betrifft eine Kompressionseinheit für einen Rahmen, der eine oder mehrere separate Einheiten für Kabeleinführungen, Rohrdurchführungen usw. aufnimmt. Die Kompressionseinheit umfasst eine Kompressionsplatte, die in dem Rahmen aufgenommen werden soll. Die Kompressionsplatte weist Vorsprünge auf, die in Rillen des Rahmens aufgenommen werden sollen. Die Rillen haben einen ersten geraden Teil und einen zweiten abgerundeten Teil. Um die Kompressionsplatte in eine Kompressionsposition zu bringen, wird die Kompressionsplatte mit einem geeigneten Werkzeug gedreht, wenn sich die Vorsprünge in den abgerundeten Teilen der Nuten befinden.

### Zusammenfassung

Aufgabe der Erfindung ist es, eine verbesserte Anordnung mit einer Wanddurchführung für mehrere Kabel und eine Verfahren zum Herstellen anzugeben, die eine flexible Anpassung an unterschiedliche Anwendungssituationen ermöglichen. Insbesondere soll die Durchführung von vorkonfektionierten Kabel durch eine Wand unterstützt werden, bei denen üblicherweise Kabelenden bestückt sind, zum Beispiel Anschlusshilfen oder -steckern.

Zur Lösung ist ein Verfahren zum Herstellen einer Wanddurchführung für mehrere Kabel nach dem unabhängigen Anspruch 1 geschaffen. Weiterhin ist eine Anordnung für eine Wanddurchführung nach Anspruch 15 vorgesehen. Ausgestaltungen sind Gegenstand von abhängigen Unteransprüchen.

Nach einem Aspekt ist eine Anordnung mit einer Wanddurchführung für mehrere Kabel geschaffen. Die Anordnung weist eine Wand mit einem Wanddurchbruch auf, durch welchen hindurch mehrere Kabel hindurchgeführt werden. Die Wand kann aus unterschiedlichen Materialien bestehen, beispielsweise Kunststoff oder Metall. In einer Ausführung kann es sich um eine Wand aus einem Blech handeln. Die Wanddurchführung weist ein Gehäuse auf, welches auf einer Seite an der Wand angeordnet ist, derart, dass ein am Gehäuse gebildeter Gehäusedurchbruch dem Wanddurchbruch gegenüberliegend angeordnet ist. Mehrere Kabel verlaufen jeweils durch den Wanddurchbruch und den Gehäusedurchbruch sowie ein zugeordnetes Dichtungselement hindurch. Die jeweils zugeordneten Dichtungselemente sind in einem Aufnahmeraum des Gehäuses das jeweilige Kabel umlaufend abdichtend angeordnet. In dem Aufnahmeraum des Gehäuses der Wanddurchführung sind mit Hilfe wenigstens eines Rasterbauteils getrennte Aufnahmen für jeweils ein oder mehrere Dichtungselemente gebildet, in welchen die die Kabel aufnehmenden und abdichtenden Dichtungselemente angeordnet sind. Das Rasterbauteil ist nach dem Anordnen des Gehäuses an der Wand von einer gegenüberliegenden Seite der Wand, bei der es sich zum Beispiel um eine Innenseite handeln kann, durch den Wanddurchbruch hindurch in dem Aufnahmeraum und dort in dem Bereich des Gehäusedurchbruchs eingeführt.

Nach einem weiteren Aspekt ist ein Verfahren zum Herstellen einer Wanddurchführung für mehrere Kabel geschaffen, wobei das Verfahren die folgenden Schritte aufweist: Bereitstellen einer Wand mit einem Wanddurchbruch; Anordnen eines Gehäuses einer Wanddurchführung auf einer Seite an der Wand, derart, dass ein am Gehäuse gebildeter Gehäusedurchbruch dem Wanddurchbruch gegenüberliegend angeordnet ist; Anordnen wenigstens eines Rasterbauteils in einem Aufnahmeraum des Gehäuses, wobei das wenigstens eine Rasterbauteil nach dem Anordnen des Gehäuses an der Wand von einer gegenüberliegenden Seite der Wand durch den Wanddurchbruch hindurch in dem Aufnahmeraum und dort in dem Bereich des Gehäusedurchbruchs eingeführt wird und hierin getrennte Aufnahmen für jeweils ein oder mehrere Dichtungselemente bereitstellt; und Anordnen von mehreren Dichtungselementen in den getrennten Aufnahmen, wobei mehrere Kabel vorgesehen sind, die jeweils durch den Wanddurchbruch und den Gehäusedurchbruch sowie ein zugeordnetes Dichtungselement hindurch verlaufen, welches in der zugeordneten Aufnahme das jeweilige Kabel umlaufend abdichtend angeordnet ist.

Eine Befestigung des Gehäuses der Wanddurchführung an der Wand mit dem Wanddurchbruch kann zum Beispiel mit Hilfe einer oder mehrerer Schrauben erfolgen. Alternativ oder ergänzend kann zum Befestigen beispielsweise ein Aufrasten vorgesehen sein.

Das Raster- oder Gitterbauteil kann zum Beispiel mittels Klemmen und / oder Rasten in dem Aufnahmeraum des Gehäuses befestigt werden.

Die Dichtungselemente können mit einer oder mehreren Kabeltüllen gebildet sein. Sie können aus einem elastischen Material bestehen, welches auf Druck elastisch nachgibt, beispielsweise einem Gummimaterial. Die Dichtungselemente können ein- oder mehrteilig ausgeführt sein. Im Fall einer einteiligen Ausführung kann ein sich vom äußeren Rand zu einer Kabeldurchführung hin erstreckender Schlitz oder Schnitt vorgesehen sein, welcher ein Öffnen des Dichtungselements ermöglicht, beispielsweise zum Einschieben eines Kabels von der Seite entlang des Schlitzes. Die Dichtungselemente können wenigstens zum Teil als ein Hohlkörper mit einem inneren und / oder einem äußeren Hohlraum oder als Vollmaterialkörper ausgebildet sein.

Das Gehäuse der Wanddurchführung kann einteilig oder mehrteilig ausgeführt sein.

Das Rasterbauteil kann als Bauteil mit einem Gitter (Gitterbauteil) ausgeführt sein, das mittels Stegen gebildet ist, welche die jeweiligen Aufnahmen teilweise oder vollständig umgreifen. Ein Teil der Stege kann unterbrochen ausgebildet sein.

In zumindest einem Teil der getrennten Aufnahmen kann genau ein Dichtungselement angeordnet sein. Es kann in sämtlichen Aufnahmen nur genau ein Dichtungselement angeordnet sein. Das jeweilige Dichtungselement kann ein oder mehrere Kabel abdichtend aufnehmen. In einer Ausführung ist in jeder Aufnahme genau ein Dichtungselement angeordnet, welches genau ein Kabel aufnimmt.

In zumindest einem Teil der getrennten Aufnahmen können mehrere Dicbtungselemente angeordnet sein. Die mehreren Dichtungselemente können die Aufnahme, in welcher sie gemeinsam angeordnet sind, vollständig ausfüllen.

Die Dichtungselemente können beim Einführen in die Aufnahme das Kabel selbsttätig klemmend und umlaufend dichtend ausgeführt sein. Hierbei können die Dichtungselemente zumindest in einer Montagestellung, in welcher sie im Wesentlichen vollständig in der zugeordneten Aufnahme angeordnet sind, druckbeaufschlagt sein, sei es durch das Rasterbauteil und / oder das Gehäuse der Wanddurchführung. Bei dieser oder anderen Ausführungsformen kann die umlaufende Abdichtung des Kabels am Dichtungselement mit Hilfe einer Dichtungslippe ausgebildet sein, die im montierten Zustand auf der äußeren Oberfläche des Kabels unterbrochen oder durchgehend angeordnet ist.

Die selbsttätige Klemm- und Dichtwirkung kann zunehmen je weiter das Dichtungselement in die Aufnahme eingeschoben ist. Die selbsttätige Klemm- und Dichtwirkung kann auf einem Einschiebeabschnitt in die Montagestellung hin kontinuierlich zunehmend ausgebildet sein.

Die Dichtungselemente können in den Aufnahmen lösbar aufgenommen sein. Das lösbare Aufnehmen kann beispielsweise dadurch ausgeführt sein, dass die Dichtungselemente in die zugeordnete Aufnahme eingesteckt oder eingeschoben sind. Die lösbare Aufnahme kann eine mehrfache Montage sowie Demontage der Dichtungsekrnente in den Aufnahmen ermöglichen.

Die Dichtungselemente und / oder die Aufnahmen können konisch ausgeführt sein. Zum Beispiel können die Dichtungselemente und / oder die Aufnahmen einen Kegelstumpfform aufweisen. In Verbindung mit dem Rasterbauteil kann vorgesehen sein, dass die Aufnahmen umgebende Stege im Querschnitt konisch ausgebildet sind. Die Neigung relativ zur jeweiligen Mittellinie des konischen Verlaufs für die Dichtungselemente einerseits und die Aufnahmen andererseits können verschieden sind.

Eine Außenfläche der Dichtungselemente und / oder eine Innenfläche der Aufnahmen kann eine Oberflächenstrukturierung aufweisen. Die Oberflächenstrukturierung kann die Reibung zwischen der Außenfläche des Dichtungselements und der Innenfläche der Aufnahme erhöhend ausgeführt sein. Komplementäre Oberflächenstrukturierungen können auf sich in der Montagestellung der Dichtungselemente gegenüberliegende Flächenabschnitten der Außenfläche des Dichtungselements und der Innenfläche der Aufnahme vorgesehen sein.

Die Dichtungselemente können auf einer proximalen und / oder auf einer distalen Stirnfläche eine randseitige Dichtlippe aufweisen, die zumindest abschnittsweise auf einer Stirnfläche des Rasterbauteils angeordnet sind. Die randseitige Dichtlippe überlappt hierbei zumindest abschnittsweise mit einer Stirnfläche des Rasterbauteils. Ist in einer Ausführungsform, bei der die Abdeckung auf der gegenüberliegenden Seite der Wand vorgesehen ist, kann die Abdeckung die randseitige Dächtlippe gegen die Stirnfläche drücken, wodurch eine zusätzliche Dichtwirkung entfaltet werden kann.

Die Stirnfläche des Rasterbauteils kann zumindest abschnittweise freiliegend gebildet sein. Die Stirnfläche des Rasterbauteils kann so bei montierter Wanddurchführung von einer oder beiden Seiten der Wand, in welcher der Wanddurchbruch gebildet ist, einsehbar sein.

Das Rasterbauteil kann lösbar in dem Gehäuse angeordnet sein. Eine lösbare Verbindung kann zum Beispiel als Rastverbindung oder Klemmverbindung ausgeführt sein. Alternativ zur lösbaren Verbindung kann eine nicht lösbare Verbindung des Rasterbauteils nach dessen Einführen in dem Gehäuse vorgesehen sein, also insbesondere eine Verbindung, die nur mittels teilweiser Zerstörung der beteiligten Bauteile wieder trennbar ist.

Ein den Gehäusedurchbruch umgehender Rand kann zumindest abschnittweise auf der Stirnfläche randseitiger Dichtungselemente aufliegen. Beispielsweise kann ein sich nach innen erstreckender oder vorstehender Rand des Gehäuses auf der Stirnfläche randseitiger Dichtungselemente aufliegen, die im Gehäuse der Wanddurchführung angeordnet sind.

Das Rasterbauteil kann einstückig ausgeführt sein. Alternativ kann das Rasterbauteil mehrteilig ausgeführt sein, beispielsweise mit mehreren Gitterbauteilen, die einzeln in den Aufnahmeraum des Gehäuses einführbar sind, um dort wahlweise miteinander verbunden zu werden, beispielsweise mittels einer Rast- oder einer Steckverbindung. Alternativ kann vorgesehen sein, dass die mehreren Rasterbauteile untereinander nicht verbunden sind, sondern nur mittels jeweiliger Verbindung zum Gehäuse der Wanddurchführung in deren Aufnahmeraum montiert sind. Dieses schließt insbesondere nicht aus, dass sich Flächen der mehreren Rasterbauteile aufeinander abstützen oder zur gegenseitigen Anlage kommen.

Auf der gegenüberliegenden Seite der Wand kann eine Abdeckung angeordnet sein. Mit der Abdeckung, zum Beispiel eine Abdeckplatte, die ein- oder mehrteilig ausgeführt ist, kann zusätzlich Druck auf die Dichtungselernente ausgeübt werden, um eine zusätzliche Dichtwirkung zu erzeugen. Bei dieser oder anderen Ausführtingsformen kann die Wanddurchführung, insbesondere hinsichtlich der Kabeldichtung, der Schutzart IP65 nach EN60529 entsprechen. Unabhängig vom Erfüllen dieses Standards kann die Abdichtung bei den verschiedenen Ausgestaltungen wenigstens einen Feuchtigkeits- und Schmutzschutz bereitstellend ausgeführt sein. Die Abdeckung, beispielweise auf der einem Innenraum zugewandten Seite der Wand, deckt den Wanddurchbruch teilweise oder ganz ab, wobei die Kabel durch eine oder mehrere Öffnungen in der Abdeckplatte verlaufen. Die Abdeckplatte kann mittels einer oder mehrerer Schrauben befestigt sein.

Bei dem Raster- oder Gitterbauteil können in distalen Eckbereichen der Stege, diese ein- oder zweiseitig erfassend, Dichtabschnitte vorgesehen sein, mit denen zwischen dem Gehäuse und dem Rasterbauteil Dichtungen ausgebildet werden, wenn das Rasterbauteil im Aufnahmeraum des Gehäuses montiert ist. Die Dichtabschnitte können an dem Rasterbauteil einstückig angeformt sein. Die Dichtabschnitte können im Vergleich zu den Stegen aus einem weicheren KunstStoffmaterial bestehen. Das Rasterbauteil kann mittels 2-Komponenten-Spritzgießen hergestellt sein. Beim Einführen des Rasterbauteils in dem Gehäuse können die distalen Eckbereiche voranlaufen, und die Dichtabschnitte können schließlich innen am Gehäuse dichtend anliegen, wenn das Raster- oder Gitterbauteil mittels Rastelementen, die benachbart zu proximalen Eckbereichen auf einer Stegaußenseite angeordnet sein können, im Gehäuse befestigt wird. Hierbei können die Dichtabschnitte zumindest in einer eingerasteten Stellung mit einem oder beiden Dichtteilabschnitten des Dichtabschnitts innen gegen das Gehäuse gedrückt sein. Die beiden Dichtteilabschnitte können über Eck in Verbindung stehen. Auf dem Dichtteilabschnitt können ein oder mehrere Dichtlippen angeordnet sein. Alternativ kann nur eine Dichtlippe vorgesehen sein. Der weitere Dichtteilabschnitt kann ergänzend eine oder mehrere Dichtlippenaufweisen oder frei hiervon sein.

Die Dichtlippenkönnen mit weiteren Dichtlippen an den Dichtelementen fluchtend angeordnet sein, wenn die Dichtelemente in den Aufnahmen sitzen. Hierbei kann ein Formschluss vorgesehen sein. Die Dichtlippen und die weiteren Dichtlippen können mit gleicher Bauhöhe ausgeführt sein. Alternativ oder ergänzend können die Dichtlippen mit weiteren Dichtlippen einen gleichen Querschnitt aufweisen. Es kann vorgesehen sein, dass im Bereich einer vorderseitigen Stirnseite der Stege Verbindungen zwischen den Dichtabschnitten in den Eckbereichen verlaufen, woran es alternativ fehlen kann. Die Verbindungen, welche schmaler als die Dichtabschnitte ausgeführt sein können, können sich wenigstens teilweise in Vertiefungen in den Stegen erstrecken, die mit Kanälen gebildet sind. Eine solche Ausbildung kann alternativ oder ergänzend für die Dichtabschnitte vorgesehen sein. Seitliche Abschnitte der Dichtabschnitte können formschlüssig an die Dichtungselemente anschließen. Eine Oberfläche der weiteren Dichtteilahschnitt kann in einer Ebene mit einer Oberfläche der Dichtungselemente liegen, An dem weiteren Dichtteilabschnitt können seitlich ein- oder beidseitig Kragenabschnitte gebildet sein.

In Verbindung mit dem Bausatz für die Wanddurchführung sowie dem Verfahren zum Herstellen können die vorangehend erläuterten Ausgestaltungen entsprechend vorgesehen sein.

### Beschreibung von Ausführungsbeispielen

Im Folgenden werden weitere Ausführungsbeispiele unter Bezugnahme auf Figuren einer Zeichnung näher erläutert. Hierbei zeigen:
- Fig. 1: eine schematische Darstellung einer Anordnung mit einem Wandabschnitt und einer Wanddurchführung für mehrere Kabel;
- Fig. 2: eine schematische Darstellung einer weiteren Anordnung mit einem Wandabschnitt und einer Wanddurchführung für mehrere Kabel;
- Fig. 3: eine Schnittdarstellung der Anordnung aus Fig. 1 ;
- Fig. 4: eine schematische Darstellung von Komponenten der Anordnung aus Fig. 1;
- Fig. 5: eine schematische Schnittdarstellung eines Abschnitts der Anordnung mit der Wanddurchführung;
- Fig. 6: eine schematische Schnittdarstellung eines weiteren Abschnitts der Wanddurchführung für mehrere Kabel;
- Fig. 7: eine perspektivische Darstellung mit einem Gehäuse und hierin aufgenommenem Rasterbauteil für eine Wanddurchführung;
- Fig. 8: eine schematische perspektivische Darstellung eines Rasterbauteils, an weichem Dichtabschnitte gebildet sind; und
- Fig. 9: eine schematische perspektivische Darstellung des Rasterbauteils aus Fig. 8, wobei in Aufnahmen Dichtungselemente angeordnet sind.

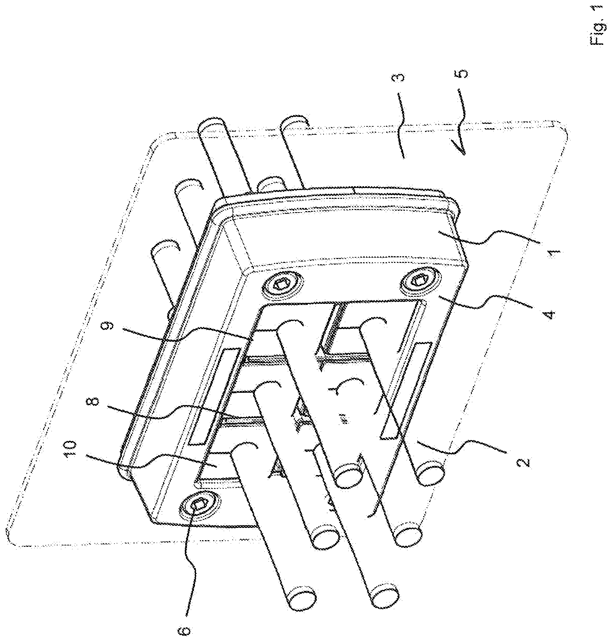

Im Folgenden werden unter Bezugnahme auf die Fig. 1 bis 7 Ausführungen für eine Wanddurchführung 1 zum gedichteten Hindurchführen von mehreren Kabeln 2 durch eine Wand 3 beschrieben, für die ein Wandabschnitt gezeigt ist. Bei der Wand 3 kann es sich beispielsweise um eine Gehäusewand eines Gerätes oder eines Schaltschranks handeln. Die Wand 3 kann zum Beispiel aus einem Blechmaterial bestehen.

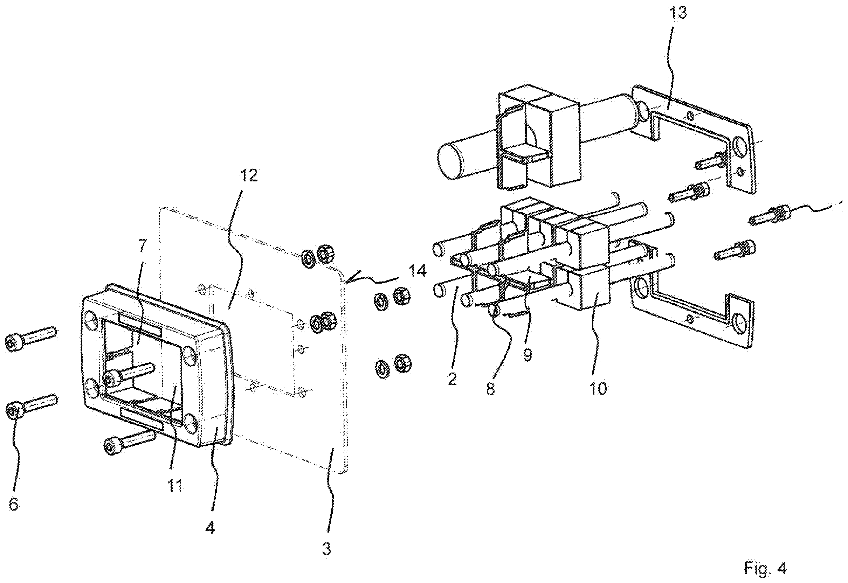

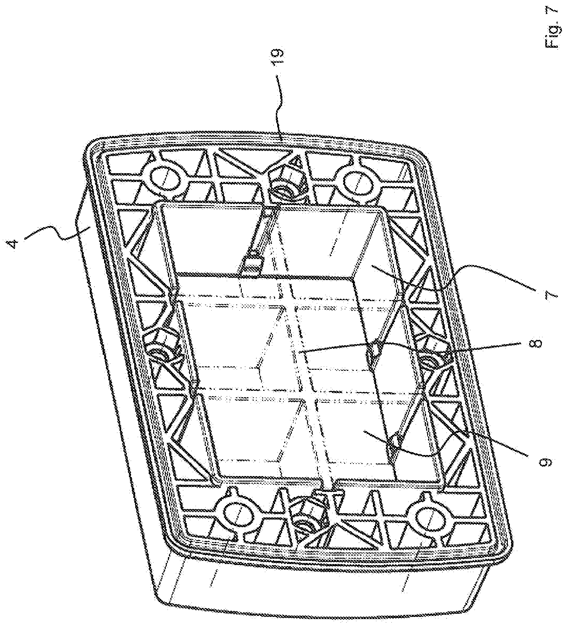

Fig. 1 zeigt eine perspektivische Darstellung einer Anordnung mit der Wanddurchführung I, die ein Gehäuse 4 aufweist, welches bei der dargestellten Ausführungsförm einteilig aus einem Kunststoffmaterial hergestellt ist, beispielsweise als Spritzgussbauteil. Das Gehäuse 4 ist auf einer Seite 5 der Wand 3 befestigt, beispielweise mittels Schrauben 6, Das Gehäuse 4 ist auf die Wand 3 aufgesetzt und stellt im Inneren einen Aufnahmeraum 7 zur Verfügung (vgl. insbesondere Fig. 4 und 7 unten). In dem Aufnahmeraum 7 ist ein Rasterbauteil 8 angeordnet. Das Rasterbauteil 8 stellt bei der gezeigten Ausführung mehrere Aufnahmen 9 zur Verfügung, in denen jeweils ein Dichtungselement 10 mit einem der mehreren Kabel 2 angeordnet ist. Das Dichtungselement 10 dichtet das jeweilige Kabel umlaufend ab, insbesondere gegen Feuchtigkeits- und Schmutzeintritt.

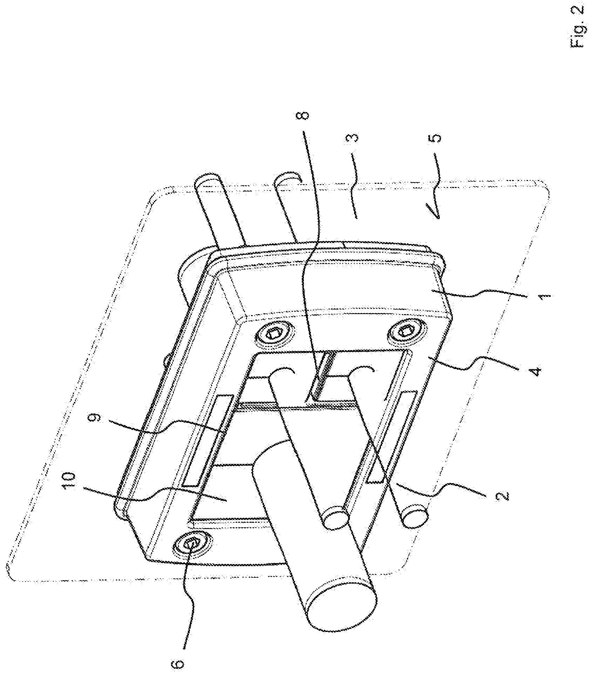

Fig. 2 zeigt eine perspektivische Darstellung einer weiteren Anordnung mit der Wanddurchführung 1 in einer anderen Ausgestaltung. Das Rasterbauteil 8 stellt in dem Aufnahmeraum 7 des Gehäuses 4 eine andere Aufteilung oder Einteilung der Aufnahmen 9 zur Verfügung.

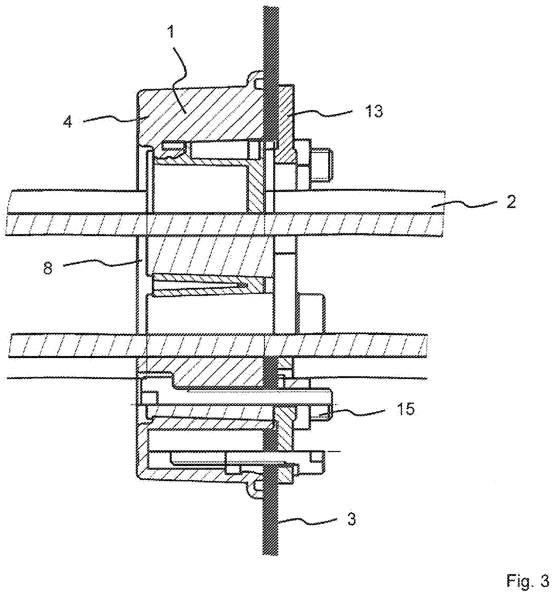

Fig. 3 zeigt eine Schnittdarstellung durch die Anordnung in Fig. 1.

Fig. 4 zeigt eine Explosionsdarstellung der Anordnung mit der Wanddurehführung 1 in der Ausgestaltung nach Fig. 1.

Insbesondere aus Fig. 4 ergibt sich, dass das Rasterbauteil 8 in dem Aufnahmeraum 7 des Gehäuses 4 einführbar ist, nachdem das Gehäuse 4 auf der Seite 5 der Wand 3 mittels der Schrauben 6 befestigt ist. Mit Hilfe der Befestigung des Gehäuses 4 wird ein Gehäusedurchbruch 11 einem Wanddurchbruch 12 gegenüberliegend angeordnet, so dass die beiden Durchbrüche wenigstens teilweise flächig überlappen. Durch den Wanddurchbruch 12 kann dann das Rasterbauteil 8 in dem Aufnahmeraum 7 eingeführt werden, um dort die Aufnahmen 9 bereitzustellen, in die dann die Dichtungselemente 10 mit dem jeweiligen Kabel eingesteckt werden. Bei der gezeigten Ausführungsform ist eine Abdeckung 13 auf einer gegenüberliegenden Seite 14 der Wand 3 vorgesehen, die ebenfalls mittels Schrauben 15 an der Wand 3 befestigt wird.

Bei der Wanddurchführung 1 ist es im Prozess der Montage somit ermöglicht, zunächst das Gehäuse 4 auf der Seite 5 der Wand 3 zu montieren, um dann durch die noch großflächige Öffnung des Wanddurchbruchs 12 und des Gehäusedurchbruchs 11 hindurch bestückte Kabelenden der mehreren Kabel 2 hindurchzuführen. Im Anschluss kann das Rasterbauteil 8 durch den Wanddurchbruch 12 hindurch in dem Aufnahmeraum 7 montiert werden, um schließlich die Dichtungselemente 10 in die Aufnahmen 9 einzustecken.

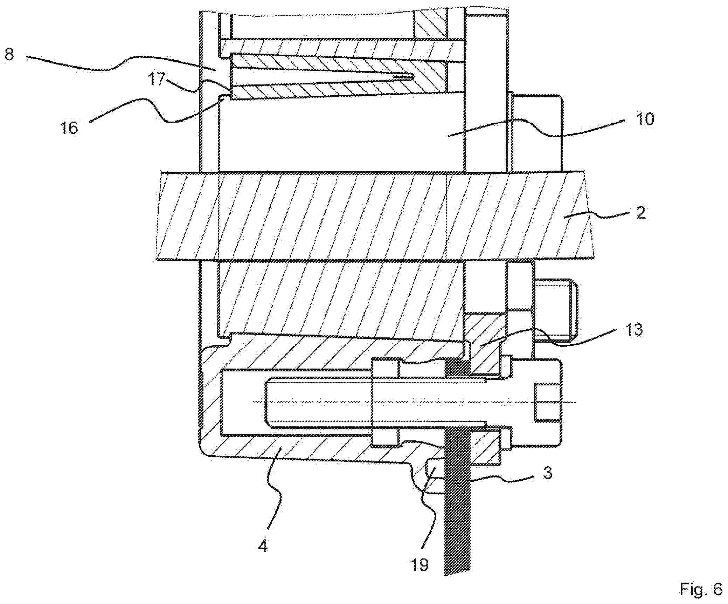

Die Dichtungselemente 10 sind bei der gezeigten Ausführungsform selbsttätig klemmend in den Aufnahmen 9, wenn die Dichtungselemente 10 hierin eingführt werden. Hierzu sind die Aufnahmen 9 konisch ausgeführt, was sich insbesondere aus Fig. 6 ergibt. Alternativ oder ergänzend können die Dichtungselemente 10 eine konische Außenform aufweisen. Aus Fig. 6 ergibt sich weiterhin, dass an den Dichtungselementen 10 eine randseitige Dichtlippe 16 gebildet ist, die auf einer Stirnfläche 17 des Rasterbauteils 8 aufliegt.

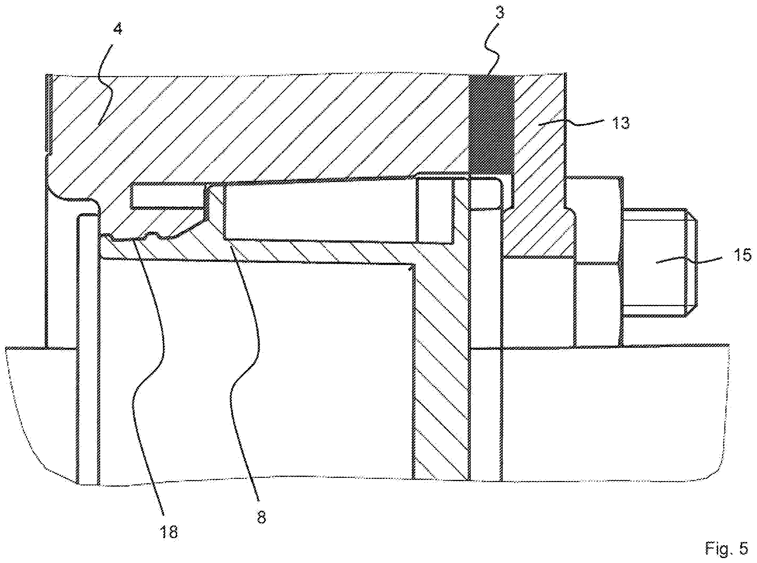

Fig. 5 zeigt eine schematische Querschnittsdarstellung eines Abschnitts der Anordnung mit der Wanddufchführüng 1. Insbesondere ergibt sich, dass das Rasterbauteil 8, welches in der gezeigten Ausführungsform als ein Einsatzrahmen ausgebildet ist, mittels einer Rastverbindung 18 an dem Gehäuse 4 montiert ist.

Fig. 7 zeigt eine perspektivische Darstellung, bei der das Rasterbauteil 8 in das Gehäuse 4 eingesetzt ist. Umlaufend ist eine Dichtlippe 19 an dem Gehäuse 4 vorgesehen.

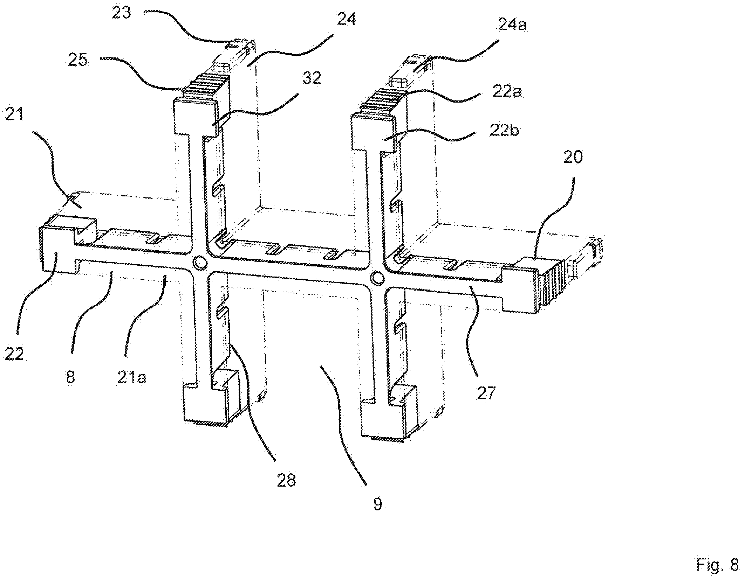

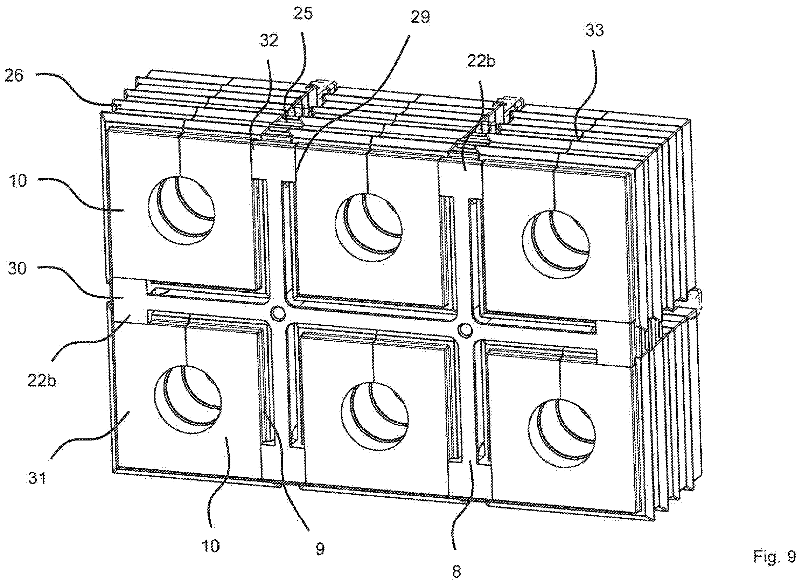

Fig. 8 und 9 zeigen schematische perspektivische Darstellungen einer weiteren Ausführung für das Rasterbauteil 8. In Fig. 9 sind in den Aufnahmen 9 die Dichtungselemente 10 angeordnet sind.

In distalen Eckbereichen 20 von Stegen 21 des Rasterbauteils 8 sind Dichtabschnitte 22 gebildet. Die Dichtabschnitte 22 bestehen im Vergleich zu den Stegen 21 aus einem weicheren Kunststoffmaterial, zum Beispiel einem auf Druckbelastung elastisch nachgebenden Kunststoffmaterial. Das Rasterbauteil 8 kann mittels 2-Komponenten-Spritzgießen hergestellt werden.

Beim Einführen des Rasterbauteils in dem Gehäuse 4 laufen die distalen Eckbereiche 20 voran und die Dichtabschnitte 22 liegen schließlich ganz oder teilweise innen am Gehäuse 4 dichtend an, wenn das Raster- oder Gitterbauteil 8 mittels Rastelementen 23, die benachbart zu proximalen Eckbereichen 24 auf einer Stegaußenseite 24a angeordnet sind, im Gehäuse 4 und / oder am Wanddurchbruch befestigt werden kann. Hierbei können die Dichtabschnitte 22 zumindest in einer eingeführten Stellung mit einem oder beiden Diehtteilabschnitten 22a, 22b des Dichtabschnitts 22 innen gegen das Gehäuse 4 gedrückt sein. Auf dem Dichtteilabschnitt 22a sind Dichtlippen 25 angeordnet. Alternativ kann nur eine Dichtlippe vorgesehen sein. Der weitere Dichtteilabschnitt 22b, welcher in einer alternativen Ausführung auch entfallen kann, kann ergänzend eine oder mehrere Dichtlippen (nicht dargestellt) aufweisen oder frei hiervon sein (vgl. Fig. 8).

Gemäß der Darstellung in Fig. 9 können die Dichtlippen 25 mit weiteren Dichtlippen 26 an den Dichtelementen 10 fluchtend angeordnet sein, wenn die Dichtelemente 10 in den Aufnahmen 9 sitzen. Hierbei kann ein Formschluss vorgesehen sein. Die Dichtlippen 25 und die weiteren Dichtlippen 26 können mit gleicher Bauhöhe ausgeführt sein. Alternativ oder ergänzend können die Dichtlippen 25 und die weiteren Dichtlippen 26 einen gleichen Querschnitt aufweisen.

Es kann vorgesehen sein, wie dies Fig. 8 und 9 beispielhaft zeigen, dass im Bereich einer vorderseitigen Stirnseite 21a der Stege 21 Verbindungen 27 zwischen den Dichtabschnitte 22 in den distalen Eckbereichen 20 verlaufen, woran es alternativ fehlen kann. Bei der gezeigten Ausführungsform erstrecken sich die Verbindungen 27 in Vertiefungen 28 in den Stegen 21, die mit Kanälen gebildet sein können, derart, dass das Material, aus denen die Verbindungen 27 hergestellt werden, von der vorderseitigen Stirnseite 21a in die Vertiefungen 28 gelangen kann.

Gemäß Fig. 9 schließen bei der gezeigten Ausführungsform seitliche Abschnitte 29 der Dichtabschnitte 22 formschlüssig an die Dichtungselemente 10 an. Eine Oberfläche 30 der weiteren Dichtteitabschnitt 22b kann in einer Ebene mit einer Oberfläche 31 der Dichtungselemente 10 liegen, was Fig. 9 zeigt. An dem weiteren Dichtteilabschnitt 22b sind seitlich Kragenabschnitte 32 gebildet.

Die Dichtungselemente 10 weisen einen Schnitt 33 auf, welcher das Öffnen, Aufweiten oder Aufspreizen der Dichtungselemente 10 ermöglicht, zum Beispiel beim Einführen eines Kabels.

Die in der vorstehenden Beschreibung, den Ansprüchen sowie der Zeichnung offenbarten Merkmale können sowohl einzeln als auch in beliebiger Kombination für die Verwirklichung der verschiedenen Ausführungen von Bedeutung sein.

## Patentansprüche

1. Verfahren zum Herstellen einer Wanddurchführung (1) für mehrere Kabel (2), die folgenden Schritte aufweisend:
- Bereitstellen einer Wand (3) mit einem Wanddurchbruch;
- Anordnen eines Gehäuses (4) einer Wanddurchführung auf einer Seite an der Wand (3), derart, dass ein am Gehäuse (4) gebildeter Gehäusedurchbruch (11) dem Wanddurchbruch (12) gegenüberliegend angeordnet ist;
- Anordnen wenigstens eines Rasterbauteils (8) in einem Aufnahmeraum (7) des Gehäuses (4), wobei das wenigstens eine Rasterbauteil (8) nach dem Anordnen des Gehäuses (4) an der Wand (3) von einer gegenüberliegenden Seite der Wand (3) durch den Wanddurchbruch (12) hindurch in dem Aufnahmeraum (7) und dort in dem Bereich des Gehäusedurchbruchs (11) eingeführt wird und hierin getrennte Aufnahmen (9) für jeweils ein oder mehrere Dichtungselemente (10) bereitstellt; und
- Anordnen von mehreren Dichtungselementen (10) in den getrennten Aufnahmen (9), wobei mehrere Kabel (2) vorgesehen sind, die jeweils durch den Wanddurchbruch (12) und den Gehäusedurchbruch (11) sowie ein zugeordnetes Dichtungselement (10) hindurch verlaufen, welches in der zugeordneten Aufnahme (9) das jeweilige Kabel (2) umlaufend abdichtend angeordnet ist.

2. Verfahren nach Anspruch 1, **dadurch gekennzeichnet, dass** in zumindest einem Teil der getrennten Aufnahmen (9) genau ein Dichtungselement (10) angeordnet wird.

3. Verfahren nach Anspruch 1 oder 2, **dadurch gekennzeichnet, dass** in zumindest einem Teil der getrennten Aufnahmen (9) mehrere Dichtungselemente (10) angeordnet wird.

4. Verfahren nach mindestens einem der vorangehenden Ansprüche, **dadurch gekennzeichnet, dass** die Dichtungselemente (10) beim Einführen in die Aufnahme (9) das Kabel (2) selbsttätig klemmen und umlaufend dichten.

5. Verfahren nach Anspruch 4, **dadurch gekennzeichnet, dass** die selbsttätige Klemm- und Dichtwirkung zunimmt je weiter das Dichtungselement (10) in die Aufnahme (9) eingeschoben wird.

6. Verfahren nach mindestens einem der vorangehenden Ansprüche, **dadurch gekennzeichnet, dass** die Dichtungselemente (10) in die Aufnahmen (9) lösbar aufgenommen werden.

7. Verfahren nach mindestens einem der vorangehenden Ansprüche, **dadurch gekennzeichnet, dass** konisch ausgeführte Dichtungselemente (10) und / oder konisch ausgeführte Aufnahmen (9) verwendet werden.

8. Verfahren nach mindestens einem der vorangehenden Ansprüche, **dadurch gekennzeichnet, dass** eine Außenfläche der Dichtungselemente (10) und / oder eine Innenfläche der Aufnahmen (9) eine Oberflächenstrukturierung aufweist.

9. Verfahren nach mindestens einem der vorangehenden Ansprüche, **dadurch gekennzeichnet, dass** die Dichtungselemente (10) auf einer proximalen und / oder auf einer distalen Stirnfläche eine randseitige Dichtlippe aufweisen, die zumindest abschnittsweise auf einer Stirnfläche des Rasterbauteils (8) angeordnet ist.

10. Verfahren nach mindestens einem der vorangehenden Ansprüche, **dadurch gekennzeichnet, dass** die Stirnfläche des Rasterbauteils (8) zumindest abschnittweise freiliegend gebildet ist.

11. Verfahren nach mindestens einem der vorangehenden Ansprüche, **dadurch gekennzeichnet, dass** das Rasterbauteil (8) lösbar in dem Gehäuse (4) angeordnet ist.

12. Verfahren nach mindestens einem der vorangehenden Ansprüche, **dadurch gekennzeichnet, dass** ein den Gehäusedurchbruch (11) umgebender Rand zumindest abschnittweise auf der Stirnfläche randseitiger Dichtungselemente (10) aufliegt.

13. Verfahren nach mindestens einem der vorangehenden Ansprüche, **dadurch gekennzeichnet, dass** das Rasterbauteil (8) einstückig ausgeführt ist.

14. Verfahren nach mindestens einem der vorangehenden Ansprüche, **dadurch gekennzeichnet, dass** auf der gegenüberliegenden Seite der Wand (3) eine Abdeckung (13) angeordnet ist.

15. Anordnung mit einer Wanddurchführung (1) für mehrere Kabel (2), hergestellt gemäß einem Verfahren nach mindestens einem der vorangehenden Ansprüche, mit
- einer Wand (3) mit einem Wanddurchbruch (12);
- einem Gehäuse (4) einer Wanddurchführung, welches auf einer Seite an der Wand (3) angeordnet ist, derart, dass ein am Gehäuse (4) gebildeter Gehäusedurchbruch (11) dem Wanddurchbruch (12) gegenüberliegend angeordnet ist; und
- mehreren Kabeln (2), die jeweils durch den Wanddurchbruch (12) und den Gehäusedurchbruch (11) sowie ein zugeordnetes Dichtungselement (10) hindurch verlaufen, welches in einem Aufnahmeraum des Gehäuses (4) das jeweilige Kabel (2) umlaufend abdichtend angeordnet ist,
wobei in dem Aufnahmeraum (7) des Gehäuses (4) mit Hilfe wenigstens eines Rasterbauteils (8), welches nach dem Anordnen des Gehäuses (4) an der Wand (3) von einer gegenüberliegenden Seite der Wand (3) durch den Wanddurchbruch (12) hindurch in dem Aufnahmeraum (7) und dort in dem Bereich des Gehäusedurchbruchs (11) eingeführt ist, getrennte Aufnahmen (9) für jeweils ein oder mehrere Dichtungselemente (10) gebildet sind, in welchen die Dichtungselemente (10) angeordnet sind.

## Claims

1. A method for producing a wall feed-through (1) for a plurality of cables (2), including the following steps:
- providing a wall (3) with a wall opening,
- arranging a housing (4) of the wall feed-through on one side of the wall (3) in such manner that a housing opening (11) formed in the housing (4) is located opposite the wall opening (12),
- arranging at least one grid component (8) in an accommodation space (7) of the housing (4), wherein after the arrangement of the housing (4) on the wall (3) the at least one grid component (8) is passed through the wall opening (12) in the accommodation space (7) and in the region of the housing opening (11) there from an opposite side of the wall (3) and provides separate receptacles (9) therein for each of one or more sealing elements (10); and
- arranging a plurality of the sealing elements (10) in the separate receptacles (9), wherein multiple cables (2) are provided, each of which passes through the wall opening (12) and the housing opening (11) as well as an associated sealing element (10), which sealing element is arranged in sealing manner in the associated receptacle (9) which sealing element is arranged to surround the respective cable (2) in a sealing manner in the associated receptacle (9).

2. The method according to Claim 1, **characterized in that** exactly one sealing element (10) is arranged in at least some of the separate receptacles (9).

3. The method according to Claim 1 or 2, **characterized in that** a plurality of the sealing elements (10) are arranged in at least some of the separate receptacles (9).

4. The method according to at least one of the preceding claims, **characterized in that** when they are inserted in the receptacle (9) the sealing elements (10) clamp the cable (2) automatically and seal it circumferentially.

5. The method according to Claim 4, **characterized in that** the automatic clamping and sealing action increases as the sealing element (10) is pushed further into the receptacle (9).

6. The method according to at least one of the preceding claims, **characterized in that** the sealing elements (10) are accommodated detachably in the receptacles (9).

7. The method according to at least one of the preceding claims, **characterized in that** conically constructed sealing elements (10) and/or conically constructed receptacles (9) are used.

8. The method according to at least one of the preceding claims, **characterized in that** an outer surface of the sealing elements (10) and/or an inner surface of the receptacles (9) has/have a surface structuring.

9. The method according to at least one of the preceding claims, **characterized in that** the sealing elements (10) have a sealing lip on the border of the proximal and/or distal end face thereof, at least a section of which is arranged on an end face of the grid component (8).

10. The method according to at least one of the preceding claims, **characterized in that** at least a section of the end face of the grid component (8) is exposed.

11. The method according to at least one of the preceding claims, **characterized in that** the grid component (8) is arranged detachably in the housing (4).

12. The method according to at least one of the preceding claims, **characterized in that** at least a section of a border surrounding the housing opening (11) bears on the end face of the outer sealing elements (10).

13. The method according to at least one of the preceding claims, **characterized in that** the grid component (8) is designed as a single part.

14. The method according to at least one of the preceding claims, **characterized in that** a cover (13) is arranged on the opposite side of the wall (3).

15. An assembly with a wall feed-through (1) for a plurality of cables (2), produced by a method according to at least one of the preceding claims, with
- a wall (3) with a wall opening (12);
- a housing (4) of the wall feed-through, which is fixed on one side of the wall (3) in such manner that a housing opening (11) formed in the housing (4) is located opposite the wall opening (12); and
- a plurality of the cables (2), each of which passes through the wall opening (12) and the housing opening (11) as well as an associated sealing element (10), which sealing element is arranged in the accommodation space of the housing (4) to surround the respective cable (2) in a sealing manner,
wherein separate receptacles (9) in which the sealing elements (10) are arranged are formed with the aid of at least one grid component (8) for each of the one or more sealing elements (10) in the accommodation space (7) of the housing (4), which grid component is passed through the wall opening (12) in the accommodation space (7) and in the region of the housing opening (11) there from an opposite side of the wall (3) after the housing (4) has been arranged on the wall (3).

## Revendications

1. Procédé, destiné à créer un passage mural (1) pour plusieurs câbles (2), comportant les étapes suivantes consistant à :
- mettre à disposition un mur (3) pourvu d'une percée murale ;
- placer un boîtier (4) d'un passage mural sur un côté sur le mur (3), de telle sorte qu'une percée dans le boîtier (11) ménagée dans le boîtier (4) soit placée au vis-à-vis de la percée murale (12) ;
- placer l'au moins un composant tramé (8) dans un espace de logement (7) du boîtier (4), après le placement du boîtier (4) sur le mur (3), l'au moins un composant tramé (8) étant introduit à partir d'un côté en vis-à-vis du mur (3) à travers la percée murale (12) dans l'espace de logement (7) et dans celui-ci, dans la zone de la percée dans le boîtier (11) et y mettant à disposition des logements (9) séparés, destinés chacun à un ou à plusieurs éléments d'étanchéité (10) ; et
- placer plusieurs éléments d'étanchéité (10) dans les logements (9) séparés, plusieurs câbles (2) étant prévus dont chacun s'écoule à travers la percée murale (12) et la percée dans le boîtier (11) et à travers un élément d'étanchéité (10) associé, lequel est placé dans le logement (9) associé, de sorte à assurer l'étanchéité périphérique du câble (2) concerné.

2. Procédé selon la revendication 1, **caractérisé en ce que** l'on place dans au moins une partie des logements (9) séparés précisément un élément d'étanchéité (10).

3. Procédé selon la revendication 1 ou 2, **caractérisé en ce que** l'on place dans au moins une partie des logements (9) séparés plusieurs éléments d'étanchéité (10).

4. Procédé selon au moins l'une quelconque des revendications précédentes, **caractérisé en ce que** lors de l'introduction dans le logement (9), les éléments d'étanchéité (10) serrent automatiquement le câble (2) et assurent son étanchéité périphérique.

5. Procédé selon la revendication 4, **caractérisé en ce que** l'effet automatique de serrage et d'étanchéité s'accroît au fur et à mesure que l'on pousse l'élément d'étanchéité (10) de plus en plus loin dans le logement (9).

6. Procédé selon au moins l'une quelconque des revendications précédentes, **caractérisé en ce que** les éléments d'étanchéité (10) sont logés de manière amovible dans le logement (9).

7. Procédé selon au moins l'une quelconque des revendications précédentes, **caractérisé en ce que** l'on utilise des éléments d'étanchéité (10) de conception conique et/ou des logements (9) de conception conique.

8. Procédé selon au moins l'une quelconque des revendications précédentes, **caractérisé en ce qu'**une surface extérieure des éléments d'étanchéité (10) et / ou une surface intérieure des logements (9) comporte une structuration superficielle.

9. Procédé selon au moins l'une quelconque des revendications précédentes, **caractérisé en ce que** sur une face frontale proximale et / ou distale, les éléments d'étanchéité (10) comportent une lèvre d'étanchéité marginale, qui est placée au moins par endroits sur une face frontale du composant tramé (8).

10. Procédé selon au moins l'une quelconque des revendications précédentes, **caractérisé en ce que** la face frontale du composant tramé (8) est conçue en étant apparente au moins par endroits.

11. Procédé selon au moins l'une quelconque des revendications précédentes, **caractérisé en ce que** le composant tramé (8) est placé de manière amovible dans le boîtier (4).

12. Procédé selon au moins l'une quelconque des revendications précédentes, **caractérisé en ce qu'**un bord entourant la percée dans le boîtier (11) repose au moins par endroits sur la face frontale d'éléments d'étanchéité (10) marginaux.

13. Procédé selon au moins l'une quelconque des revendications précédentes, **caractérisé en ce que** le composant tramé (8) est réalisé d'un seul tenant.

14. Procédé selon au moins l'une quelconque des revendications précédentes, **caractérisé en ce que** sur le côté opposé du mur (3) est placé un couvercle (13).

15. Ensemble doté d'un passage mural (1) destiné à plusieurs câbles (2), créé d'après un procédé selon au moins l'une quelconque des revendications précédentes, comprenant
- un mur (3) doté d'une percée murale (12) ;
- un boîtier (4) d'un passage mural, lequel par un côté est placé sur le mur (3), de telle sorte qu'une percée dans le boîtier (11) ménagée dans le boîtier (4) soit placée au vis-à-vis de la percée murale (12) ; et
- plusieurs câbles (2), dont chacun s'écoule à travers la percée murale (12) et la percée dans le boîtier (11) et à travers un élément d'étanchéité (10) associé, lequel est placé dans un espace de logement du boîtier (4), en assurant l'étanchéité périphérique du câble (2) concerné,
dans l'espace de logement (7) du boîtier (4), à l'aide d'au moins un composant tramé (8), qui après le placement du boîtier (4) sur le mur (3) est placé à partir d'un côté en vis-à-vis du mur (3) à travers la percée murale (12) dans l'espace de logement (7) et y est introduit dans la zone de la percée dans le boîtier (11) étant formés des logements (9) séparés pour chacun un ou plusieurs éléments d'étanchéité (10), dans lesquels sont placés les éléments d'étanchéité (10).
